Europäisches Patentamt

European Patent Office

Office européen des brevets

(11) Publication number: 0 394 735 A2

## EUROPEAN PATENT APPLICATION

(21) Application number: 90106785.0

(51) Int. Cl.5: C23C 16/26, C23C 16/50

(22) Date of filing: 09.04.90

(30) Priority: 20.04.89 US 340995

(43) Date of publication of application:
31.10.90 Bulletin 90/44

(84) Designated Contracting States:
BE DE FR GB NL SE

(71) Applicant: HERCULES INCORPORATED
Hercules Plaza
Wilmington Delaware 19894(US)

(72) Inventor: Calcote, Hartwell Forrest
159 Philip Drive
Princeton, New Jersey 08540(US)

(74) Representative: Lederer, Franz, Dr. et al
Lederer, Keller & Riederer, Patentanwälte,
Lucile-Grahn-Strasse 22
D-8000 München 80(DE)

(54) Process for forming diamond coatings using a silent discharge plasma jet process.

(57) A process for forming diamond coatings is disclosed, in which a gas or a mixture of gases is passed through a low temperature silent discharge to generate a low temperature non-equilibrium plasma gas stream, the plasma gas stream is adiabatically expanded into a region of lover pressure to ford a plasma gas stream of highly ionized and dissociated gases, a carbon-containing gas is injected into the plasma gas stream during or after the expansion into a region of lower pressure, and the plasma gas stream is then directed onto the surface of a substrate to form the diamond coating.

FIG. I

EP 0 394 735 A2

This invention relates to processes for preparing diamond coatings.

The mechanical, thermal, electrical and optical properties of diamond films offer major advantages in a number of areas including providing extremely hard surfaces, improving semiconductors that can benefit from their high thermal conductivity and electrical insulating properties, and window applications that benefit from their transparency to photons.

The preparation of diamond coatings using plasma chemical vapor deposition (CVD) is well known. Plasma CVD involves forming a plasma containing activated free radicals, atoms, ions, and electrons (often called "activated species"), by using a direct current (dc), low frequency, radio frequency (RF), or microwave discharge and then contacting a substrate with the highly ionized and dissociated plasma gas to form a diamond coating.

The electrical discharges used to form such plasmas such as glow, corona, radio frequency, microwave, electrode less, and the so-called ozonizer discharges on the one hand, and arc discharges on the other hand, can generally be divided respectively into low temperature processes and high temperature processes.

In high temperature discharges, such as electrical arcs, the concentration of activated species requires a thermodynamic equilibrium favoring the activated product. In order to produce a significant amount of activated species, extremely high temperatures, e.g. temperatures of at least 4000°K are required. Temperatures as high as 10,000 to 30,000°K may be used, which means that most of the heat is used to heat the gas, a great amount of power is required, and the substrate is heated to the extent that graphite and amorphous carbon may be formed instead of diamond, and even to the extent that the substrate may be destroyed, unless the substrate is cooled. Problems associated with the thermal stability of the substrate and differences between the coefficients of expansion of the substrate and the deposited diamond film limit the types of substrates that can be used.

For instance, in a high temperature system described in Kurihara et al., Appl Phys. Lett., 52(6) 19:pp 437 and 438 (1988) and in European Patent Application 0286306 a thermal plasma is formed by passing a mixture of methane and hydrogen through an arc discharge and injecting methane into the area of the arc or below it. The plasma is passed through a nozzle, expanded to precipitate diamond and finally directed onto a substrate. Kurihara et al. suggest that the problem of forming graphite or amorphous carbon on the substrate because of the high temperatures can be overcome by water-cooling the substrate.

Methods for preparing diamond films that do not require a thermodynamic equilibrium favoring the activated product, that is, by generating a low temperature non-equilibrium plasma for chemical vapor deposition, have been described. Low temperature discharges, include glow discharges, coronas, electrodeless discharges, and ozonizer discharges, as well as some RF and microwave discharges, are generically known as as "silent discharges". Chemical activation in low temperature systems results in a non-equilibrium product of the activated species. The concentration of ions and free radicals in such plasmas is much greater than would be expected on the basis of thermal equilibrium considerations.

The use of a non-equilibrium plasma jet in a different context is described in a report entitled "Synthesis of Silane and Silicon in a Non-equilibrium Plasma Jet", authored by H. F. Calcote (U.S. Department of Energy/Jet Propulsion Laboratory Report 954560-76/8), which discloses forming the plasma by a DC discharge, subsequently expanding it through a nozzle to form a plasma jet, and directing the jet upon a substrate to prepare adherent silicon films.

The use of a low temperature plasma produced by passing a mixture of plasma-producing gasses, including a carbon-containing gas, through a glow discharge to form diamond coatings is suggested in U.S. Patent No. 4,767,608, but the process it discloses as being useful actually forms a high temperature plasma CVD by using an electric arc discharge to decompose a carbon source and generate a plasma gas containing carbon ions or carbon radicals. The plasma gas is subsequently adiabatically expanded the to precipitate diamond on a substrate. Since this patent also states that the process using a low temperature plasma results in a very slow rate of diamond growth, it strongly suggests that any one of the low temperature processes is not effective.

There is a need for a different approach to forming diamond coatings, namely, a process that does not waste energy by heating the carbon-containing gas to a high temperature as in an arc jet, while increasing the rate of deposition on a substrate as compared to the rate attained using any known low temperature silent discharge process.

According to the invention, a process for forming diamond coatings in which a plasma-producing gasses or mixture of gases is passed through a low temperature silent discharge to generate a low temperature non-equilibrium plasma gas stream, the plasma gas stream is adiabatically expanded into a region of lower pressure to form a plasma gas stream of highly ionized and dissociated gases that is then directed onto the surface of a substrate, is characterized in that a carbon-containing gas is injected into the high velocity plasma gas stream during or after the expansion into a region of lower pressure.

Although according to statistical mechanics the term temperature in a non-equilibrium plasma is not correct, the effective temperature of the plasma produced by the silent discharge is regarded as being in the range of 500 to about 2000° K, preferably from about 1300 to about 1800° K. These temperature ranges achieve a degree of ionization and dissociation very far out of equilibrium; in fact, to obtain the same degree of ionization and dissociation thermodynamically, the gas would have to be heated to several thousand degrees Kelvin. The low temperature, and the fact that neither the carbon forming gas nor the products that are formed when it reacts with the activated hydrogen are exposed to the discharge minimizes the occurrence of unwanted side reactions.

The plasma-producing gas or mixture of gases that is initially present when the plasma is formed by the silent discharge is hydrogen, either alone or in a mixture of other gasses, which may include helium or another inert gas. The inert gas helps to stabilize the discharge.

The amount of the carbon containing gas added can be varied from about 0.1 to about 70 mol % of hydrogen depending on which gas is used. For example, for methane the concentration is preferably from about 0.5 to 3 mol % based on the hydrogen and for carbon monoxide it is preferably from about 10 to 40 mol %.

Representative carbon containing gases include hydrocarbons containing one to four carbon atoms such as methane, which is preferred, alcohols containing one to four carbon atoms, such as ethanol, and other oxygen-containing hydrocarbons containing one to four carbon atoms such as acetone and carbon monoxide. The mixture may also contain from about 5 to about 30 mol %, preferably about 10 mol %, of the inert gas.

The process can be carried out if some carbon-containing gas is mixed with the hydrogen, in which case the plasma produced by the discharge may initially already contain the activated products of a mixture of hydrogen and some carbon-containing gas when the carbon containing gas is subsequently added in or downstream of the throat of the nozzle.

Apparatus for producing a non-equilibrium plasma jet and the principles of its operation are already well known, for instance from U.S. Patent 3,005,762. when relatively low voltages up to a few hundred volts are impressed on a pair of electrodes between which a gas is passing, a small current, on the order of microamperes, is produced. As the voltage between the two electrodes increases, the current also increases. The increase in current flow with voltage is attributable to an increase in the number of ions and electrons in the gas. As the applied voltage is increased still further, the number of ions continually increases, increasing the flow of current with little or no increase in voltage. That region of increasing current with little change in voltage is the region of a glow discharge.

If the applied voltage is increased still further in the region of the glow discharge, when a critical potential difference is reached (usually on the order of thousands of volts and specifically depending upon the electrode distance, the chemical nature of the gas, and the pressure and temperature of the gas), a point is reached with increasing current at which there occurs a sudden increase in current flow to the order of many amperes, the potential difference between the two electrodes drops to a few volts, and there occurs what is known as a high-current arc. The arc is maintained by copious emission of electrons from the cathode. Thus in arc-producing devices the cathode deteriorates and has to be periodically replaced. A further problem is that particulate material from the cathode becomes a part of the plasma and a potential contaminant for any deposition made by the plasma, which would destroy the utility of the coating for electronic applications.

The electrical discharge phenomena described can be brought about with either alternating or direct electric current. when alternating current of sufficient frequency is employed, the electrodes do not need to be in contact with the discharged gas and may be separated from the discharge by a dielectric material such as a quartz or PYREX tube. In such cases, the current flow in the gas occurs by induction and the resulting discharge is frequently termed an electrodeless discharge.

Since the present invention uses a low temperature silent discharge, it of course relates only to the type of low temperature processes already described (glow, corona, RF, microwave, electrodeless, and ozonizer discharges occurring prior to onset of an arc), all operated at low current densities and high voltages. The current densities are on the order of milliamperes to amperes per square centimeter, and the voltages involved are of a relatively high magnitude. Preferably, a dc glow discharge, a radio frequency (rf) discharge, or a microwave discharge is used to activate the gas.

By introducing the gas into the discharge chamber at relatively low velocity, where it is subjected to the silent discharge, non-equilibrium concentrations of activated species are produced by the discharge with efficient utilization of energy and with relatively low substrate temperatures. If a high temperature arc discharge were to be used, these advantages of the invention would be lost.

In the drawings;

FIGURE 1 shows diagrammatically the basic apparatus for carrying out the process of the invention when a dc glow discharge is used to activate the gas.

FIGURE 2 shows diagrammatically an embodiment of the apparatus for carrying out the process of the invention, when a radio frequency (RF) discharge is used to activate the gas.

FIGURE 3 shows diagrammatically an embodiment of the apparatus for carrying out the invention when a microwave discharge is used to activate the gas.

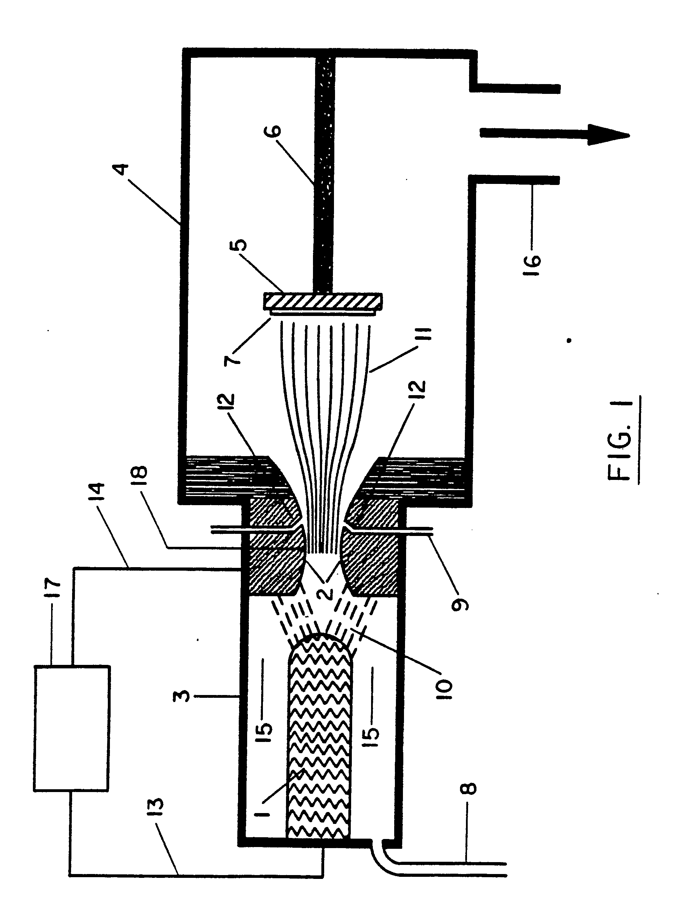

Reference is made to FIGURE 1, a schematic diagram of the basic arrangement of the apparatus for practicing the present invention. The hydrogen gas or a mixture of hydrogen and other gasses is introduced through a reactant input duct 8 into the discharge chamber 3. The gas flow 15 passes through a discharge chamber 3, through an electrical discharge 10, and through the nozzle 2, to form a higher velocity jet 11 that strikes the substrate 7. The electrical discharge that converts the gas passing through it into a plasma is produced by the application of an electrical potential from power supply 17, through electrical feed lines 13 and 14 across the gap between the electrode 1, and the nozzle 2, which acts as the other discharge electrode. The power supply 17 may produce an alternating or direct current.

If alternating current is used. and it is desired to use an electrodeless discharge, a well known and simple modification of the the discharge chamber 3 can be made by incorporating of a dielectric material such as a quartz or PYREX tube, so that the current flow in the gas occurs by induction through that material.

Conventionally, the metal of the electrodes can be of various kinds but should have high thermal conductivity. At high-current densities, or when metals of lower melting points, such as copper or aluminum, are employed, it may be necessary to cool the electrodes conventionally, such as by circulation of a fluid such as water through channels in the electrodes. In cases where the coolant is electrically conductive, a sufficiently long path through non-conductive tubing must be provided for the coolant to any non-grounded electrode, 1 or 2, in order to prevent leakage of electric current through the coolant to the ground.

The optimum pressure in the discharge chamber depends upon a number of factors such as electrode distance and shape, power supply voltage, the nature of the gas, and the frequency of the current when an alternating current is employed. At low frequencies or with direct current, it is usually desirable to have the discharge chamber 3 at a pressure from about 1.333 kPa to about 101.324 kPa (about 10 to about 760 torr), preferably from about 4 kPa to about 53.328 kPa (about 30 to about 400 torr).

The nozzle 2 provides a means of expanding the plasma from the discharge chamber 3 into the expansion or deposition chamber 4. The plasma flows through the nozzle 2 and is accelerated, because of the pressure drop between the discharge chamber 3 and the expansion chamber 4, to a higher velocity at a reduced temperature. The temperature of the expanded plasma jet as it passes into the expansion chamber 4 can be estimated from the pressure ratio:

$$T_{EC} = \left(\frac{P_E}{P_{DC}}\right)^2 T_{DC}$$

where $T_{DC}$ is the gas dynamic temperature in the discharge chamber, $T_{EC}$ is the temperature of the jet in the expansion chamber, and $P_{DC}$ and $P_{EC}$ are the pressure in the discharge chamber and the expansion chamber, respectively. The temperature in the discharge chamber is estimated from the pressure increase when the discharge is turned on. The pressure in the expansion chamber 4 is always maintained at a value less than that in the discharge chamber 3, and is generally from about 0.1332 kPa to about 13.3322 kPa (about 1 to about 100 torr), preferably from about 0.666.1 kPa to about 6.661 kPa (about 5 to about 50 torr). In this embodiment a vacuum pump, not shown, is connected to the expansion chamber 4 through an exhaust duct 16 containing a suitable conventional means for the regulation of pressure within the expansion chamber 4.

The area of the throat of the nozzle 2 is principally determined by the velocity that is desired in the jet as it strikes the substrate, and the mass rate of flow of gas desired. They are determined by the dimensions of the substrate to be treated and its orientation to the stream. These factors can be varied over wide ranges according to well known conventional principles.

If high enough pressure ratios are employed, the jet velocities may reach several times the local speed of sound in the gas. Thus, velocities on the order of thousands of feet per second may be obtained, depending upon the molecular weight and specific heat ratios of the gas, its initial temperature prior to expansion, and the pressure ratio existing between the two chambers.

Preferably, the construction of the nozzle 2 is such as to impart sonic, or supersonic, velocities to the reactive gas, so as to increase the velocity and thus the rate of deposition, while reducing the time available for the reactants to decay. After expansion, the plasma jet will typically have a temperature in the range of from about 250°K to 1800°K, and more preferably is 250°K to 1400°K.

Preferably, as in the embodiment illustrated, the carbon containing gas is introduced in the exit section of the nozzle downstream of the nozzle throat 18 (the smallest diameter of the nozzle) through input ducts 9 connected to a plurality of orifices 12, to rapidly mix with the plasma 10 produced by the discharge to form the plasma jet 11. The velocity of the injected gas is mainly determined by the pressure drop across the orifices 12.

The plasma jet 11 is directed so that it contacts a substrate 7. The substrate is positioned in the expansion chamber 4 using a substrate holder 5, mounted on a positioning rod 6 that allows movement of the substrate towards or away from the nozzle 2. The substrate will generally be located from about 2 to 30 cm, preferably from about 6 to 10 cm from the nozzle.

The relatively high temperature of the plasma and the velocity of the plasma jet when it impinges on the substrate will heat the substrate to temperatures very close to the temperatures in the discharge chamber 3. This occurs because the random energy that defines temperature has been converted to directed energy, high gas velocity, in the downstream section of the nozzle, simultaneously causing a decrease in gas temperature. when this jet strikes the substrate, the gas jet is suddenly stopped and the directed energy returned to random energy through a shock wave that is produced in front of the substrate. The energy is conserved.

Consequently, under some conditions of operation, it may be necessary to cool the substrate, so that the substrate holder may be provided with cooling means, not shown. The substrate is preferably maintained at a temperature between 300 and 1100°K. Under other conditions of operation, it may be desirable to supply additional heat to the substrate, so that the substrate holder may be provided with conventional means for heating the substrate, not shown.

Preferably, the substrate will be oriented substantially perpendicular to the flow of the plasma jet. This will tend to maximize the rate of deposition of the diamond coating. However, the substrate holder may be provided with means for pivoting the substrate so that the area that is contacted may be changed from a circle to an oval, thus increasing the coating area.

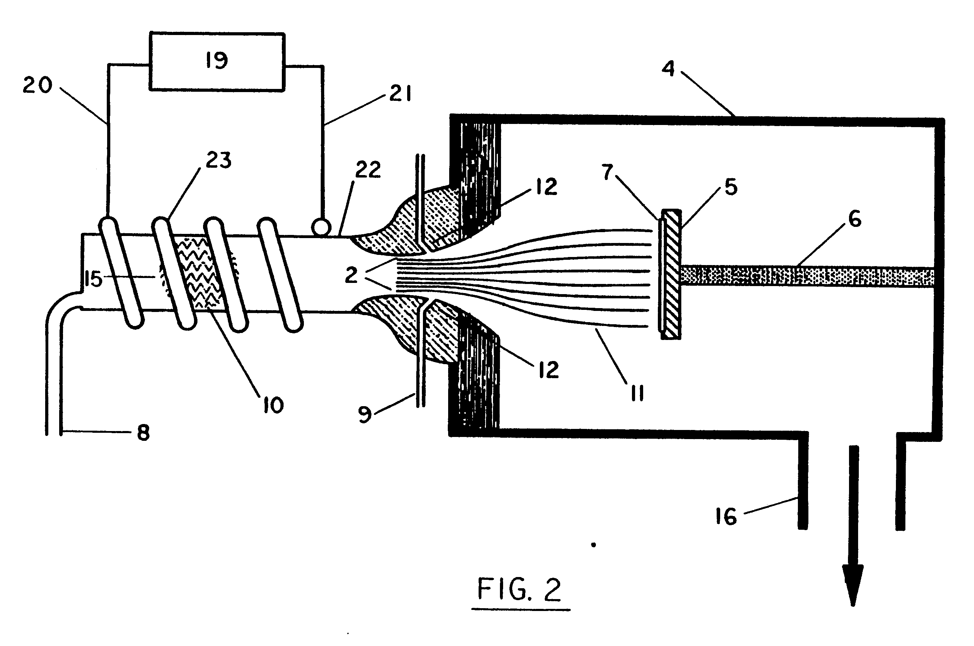

Reference is made to FIGURE 2, which shows an embodiment employing a radio frequency (rf) electrical discharge to activate the gas, instead of the dc discharge described above. Power supply 17 of Fig. 1 is replaced by a radio frequency power supply 19 and the electrical leads 13 and 14 are replaced by electrical leads 20 and 21 which may then be coaxial cables to reduce electrical losses when higher rf frequencies are employed. Discharge chamber 3 of Fig. 1 is replaced by discharge chamber 22 made of a nonconducting substance, e.g. quartz or PYREX and is surrounded by an rf coil 23. The dimensions and number of turns in coil 23 conventionally depend upon the frequency and impedence requirements of the rf power supply 19. This will be readily determined by one skilled in the art. At higher power levels it will be necessary to cool coil 23, by passing a cooling fluid such as water through it (not shown in the figure). when a conducting fluid is used it will have to be isolated from electrical ground, e.g. by passing it through a long length of nonconducting tubing so that the length of conducting liquid used has a high electrical resistance to ground. The rf power is inductively coupled to the gas passing through the discharge chamber 22 producing an rf electrical discharge inside chamber 22. This type of discharge avoids electrodes being in contact with the gas and is thus useful when unusually pure diamonds are required, for instance for use in semiconductors. All other components in Figure 2 are the same as those identified in Figure 1.

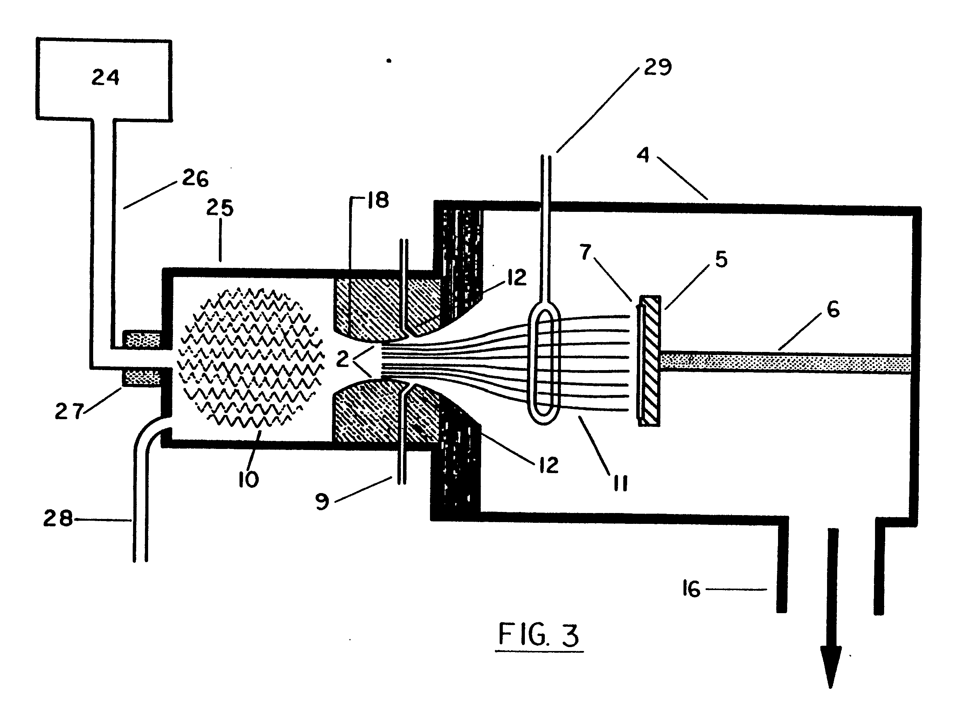

In another embodiment of the invention, as shown in Figure 3, the electrical power that activates the gas is furnished by a microwave power supply 24 coupled to the discharge chamber 25 through an appropriate wave guide 26 and coupling device 27. The discharge chamber 25 also serves as a microwave resonant cavity so that the high electromagnetic fields created therein ionize the gas fed to chamber 25 through feed line 28 to create a plasma. Also shown is ring injector 29, which serves to direct and concentrate the carbon-containing gas so that a higher proportion of the gas contacts the substrate. Although not shown in Figures 1 and 2, a ring injector can be employed in the apparatus shown in those Figures for the same purpose. The ring injector 29 may also be used to inject an additional reactant gas downstream of the nozzle. This embodiment allows the substrate to be positioned further from the nozzle while retaining the ability to adjust the substrate-to-nozzle distance independently of the distance between the substrate and the point of downstream injection. This flexibility allows for greater control of process parameters leading to optimization of diamond growth conditions. All other components of Figure 3 are the same as those identified in Figure 1.

Representative substrates include silicon, nickel, gallium arsenide, titanium, copper, copper-carbon composite, aluminum nitride, silicon carbide, aluminum-silicon-carbon composite, alumina, molybdenum, gold, spinel, silica, tungsten, graphite, copper-tungsten alloys and silicon-iron.

Surprisingly, the process according to the invention results in the production of diamond coatings on the substrate, instead of any of the many other forms of carbon such as graphite, amorphous carbon, hydrogenated carbon, glassy carbon or other carbon allotropes. This is confirmed by Raman spectroscopy, in the following examples, with the characteristic diamond peak seen at about 1332 $cm^{-1}$. The exact location of the peak is determined by a number of factors, e.g. the strain between the film and the substrate. The purity of the diamond deposit is indicated by the height of the scattered Raman peak and the peak width. A diamond quality factor, Q, is used herein to refer to the ratio of the peak intensity above the underlying continuum to the intensity of the underlaying continuum above the minimum in the baseline in the range of 500 to 1700 $cm^{-1}$. This continuum is probably associated with graphite, which has a scattering efficiency about 100 times that of diamond. Quality factors as high as 27 have been observed. It is to be understood, however, that as in natural diamonds, small amounts of impurities, such as hydrogen, nitrogen or silicon may be present. In some embodiments it may actually be desirable to introduce "impurities", such as when the diamond coating is doped to form p- and n-type materials.

### EXAMPLE 1

The apparatus show in Figure 1 was operated for 6 hours at an applied voltage of 1095 volts and current of 2.0 amperes, with a discharge power of 2200 W while feeding hydrogen at 23.7 mmole/s and helium at 2.37 mmole/s through feed line 8. Methane was added at 0.13 mmole/s in the nozzle through feed line 9 and orifices 12. The pressure in the plasma chamber was 127 torr and that in the deposition chamber was 17 torr. The discharge gas temperature was about 1600° K and the expanded jet temperature was 900° K. A silicon substrate, 8 cm downstream of the nozzle, was maintained at a temperature of 1100° K by the addition of 200 watts of electrical energy to the substrate holder 5. A diamond film having an average thickness of 1-2 microns was deposited over the entire 16 $cm^2$ exposed surface of the substrate. A Raman spectrum of the film exhibited the diamond feature at 1332 $cm^{-1}$ on an underlying continuum of comparable magnitude. X-ray diffraction analysis of the film confirmed the presence of crystalline diamond with some $\alpha$-SiC at the interface. There was no indication of the presence of graphite, yet the Q was only 0.51.

### EXAMPLE 2

Hydrogen, helium, and oxygen, at the respective flow rates of 23.7, 2.37, 0.024 mmole/s were fed to the discharge in Figure 1 through feed line 8. A silicon substrate maintained at about 1000° K was positioned at a 30° angle to the jet axis 7 cm from the nozzle. With the discharge operating at 2360 W, 1180 volts and 2 amperes, the discharge gas temperature was 1640° K. Methane was added at 0.39 mmole/s to the jet through a ring injector located 2 cm downstream of the nozzle, at the above conditions for 305 min. A diamond film having a mean thickness over a 6 $cm^2$ area of 0.6 microns was produced on the substrate. The film gave a Raman spectrum with the diamond feature near 1332 $cm^{-1}$ with a quality factor, Q = 22.

### EXAMPLE 3

A molybdenum substrate was maintained at a temperature of 940° K (by heating it electrically) at a distance of 9 cm from the nozzle of the apparatus shown in Figure 1. Hydrogen and helium gases were fed at respective flows of 23.7 and 2.37 mmole/s to the discharge through feed line 8. While operating the discharge at 2500 W and 228 torr, methane was added at 0.39 mmole/s to the downstream jet through feed line 9. This resulted in a discharge gas temperature of 2330° K and an expanded jet temperature of 1170° K. Operation at these conditions for one hour resulted in production of a 16 $cm^2$ diamond film covering the exposed surface of the substrate and having a maximum thickness of 2-3 microns. A Raman spectrum of the film exhibited the diamond feature at 1334 $cm^{-1}$.

### EXAMPLE 4

In a similar experiment to that described in Example 5, a molybdenum substrate was maintained at a temperature of 1065° K. by electrical heating at a distance of 9 cm from the nozzle of the apparatus shown in Fig. 1. Hydrogen and helium gases were fed at respective flows of 23.7 and 2.37 mmole/s to the discharge through feed line 8. while operating the discharge at 2500 W and 228 torr, a mixture of 0.77 mmole/s of methane and 0.08 mmoles/s of oxygen were added to the downstream jet through feed line 9. Operation at these conditions for one hour resulted in production of a 16 cm² diamond film covering the exposed surface of the substrate and having an average film thickness of 4-5 microns. A Raman spectrum of the film exhibited the diamond feature at 1338 cm⁻¹.

## EXAMPLE 5

In a similar experiment the apparatus of Figure 1 was used except no energy was applied to the substrate holder which was allowed to seek its own temperature, 815°K. The substrate was quartz placed 7.5 cm from the nozzle exit, hydrogen and helium were fed through the discharge at 23.7 and 2.37 mmole/s respectively, 0.39 mmole/s of methane were injected into the nozzle exit section through feed line 9, and the discharge was operated at 2180 watts at a total pressure of 139 torr. This resulted in a discharge gas temperature of 1600°K and an expanded jet temperature of 860°K. The pressure in the deposition chamber was 17.4 torr. A diamond film was deposited as indicated by the Raman peak with a quality factor of 2.8.

## EXAMPLE 6

In another experiment using the apparatus shown in Figure 1, a molybdenum substrate was held 9 cm from the nozzle exit, and was heated only by energy from the downstream jet expanding from an upstream pressure of 224 torr into the deposition chamber at a pressure of 17 torr. Feeding a mixture of hydrogen at 23.7 mmole/s and helium at 2.37 mmole/s through line 8 to the discharge operated at 2050 W, and feeding methane to the downstream jet at 0.39 mmole/s through line 9, resulted in a substrate temperature of 715°K. Operation in this manner for 8 hours produced a diamond film on the substrate as evidenced by a characteristic Raman feature at 1333 cm⁻¹ with a quality factor greater than 1.

## EXAMPLE 7

In an experiment using the apparatus shown in Figure 1, a silicon substrate was held 11 cm from the nozzle exit at a 30 degree angle relative to the jet and was heated only by energy from the downstream jet expanding from an upstream pressure of 140 Torr into the deposition chamber at a pressure of 18 Torr. A mixture of hydrogen at 23.7 mmole/s, helium at 2.37 mmole/s, and methane at 0.39 mmole/s was fed through line 8 to the discharge operated at 2500 W, and additional methane was fed to the downstream jet at 0.26 mmole/s through line 9. A substrate temperature of about 1100 K was maintained using additional heating of the backside with a radiant heater. Operation in this manner for 1 hour produced a diamond film on the substrate as evidenced by a characteristic Raman feature at 1333 cm⁻¹. The mass equivalent diamond deposition rate was 1.7 micron/h over a 9 cm 2 surface area of the substrate.

## EXAMPLE 8

An experiment was performed in which a molybdenum substrate was mounted on a water-cooled copper block and positioned 5 cm downstream from the nozzle exit as in Figure 1. For a period of one hour, 2.9 mmole/s of helium mixed with 29 mmole/s hydrogen was fed through line 8 to a 2440 W discharge operating at 207 Torr; and 0.32 mmole/s of methane was fed to the downstream jet using line 9. During this period, a thermocouple welded to the front surface of the substrate recorded temperatures below 575 K after an initial, brief, maximum temperature of 583 K. A diamond film was deposited in the area of the thermocouple bead as evidenced by Raman spectra with diamond features at 1333 cm⁻¹ and having quality factors, Q 2.5 to 4.2. Beta backscattering measurements indicated a deposition rate of 0.4 micron/h.

## EXAMPLE 9

Operation of the apparatus in Figure 1 by supplying 23.7 mmole/s hydrogen and 2.37 mmoles helium through line 8 to a 2400 W discharge at a pressure of 260 Torr and feeding 0.39 mmole/s methane to the downstream jet through line 9 resulted in heating an aluminum nitride substrate, 6 cm from the nozzle exit and at an ambient pressure of 17 Torr, to a temperature of 840 K. A diamond film was deposited at a rate greater than 10 micron/h exhibiting characteristic Raman diamond peaks near 1338 cm⁻¹.

## EXAMPLE 10

Operating the apparatus in Figure 1 in the same manner (same discharge power and pressure; same gas flows) as in Example 9, but with a silicon carbide substrate positioned 6 cm downstream of the nozzle exit resulted in a substrate temperature of about 740 K. A diamond film having a characteristic Raman peak with a quality factor Q = 3 was deposited at a peak rate of about 10 micron/h.

EXAMPLE 11

A silicon nitride substrate was positioned 6 cm downstream of the nozzle inlet, and 29 mmole/s hydrogen with 2.9 mmole/s helium were fed through line 8 to a 218 Torr, 2700 W discharge, as shown in Figure 1. To the jet was fed 0.32 mmole/s methane through line 9. The substrate temperature was raised to about 1125 K using 500 W of additional electrical heating, and after 12.5 h operation in this mode, an adherent diamond film having an average thickness of 10 microns and exhibiting a characteristic Raman diamond peak at 1334 cm$^{-1}$ with a quality factor Q = 5. The adherence of the film was evidenced by survival of a sandblast test using glass beads and by survival of the film-substrate interface when used in a machining operation.

## Claims

1. A process for forming diamond coatings in which a plasma-producing gas or mixture of gases is passed through a low temperature silent discharge to generate a low temperature non-equilibrium plasma gas stream, the plasma gas stream is adiabatically expanded into a region of lower pressure to form a plasma gas stream of highly ionized and dissociated gases that is then directed onto the surface of a substrate, characterized in that a carbon-containing gas is injected into the plasma gas stream during or after the expansion into a region of lower pressure.

2. A process for forming diamond coatings as claimed in claim 1, further characterized in that the temperature of the plasma gas stream is 250 to 1400° K.

3. A process for forming diamond coatings as claimed in claim 1 or 2, further characterized in that neither the carbon-containing gas nor the products that are formed when it reacts with the activated hydrogen are exposed to the discharge.

4. A process for forming diamond coatings as claimed in claim 1, 2, or 3, further characterized in that the plasma gas stream is passed through a nozzle from which it expands into an expansion chamber forming the region of lower pressure

5. A process for forming diamond coatings as claimed in claim 4, further characterized in that the substrate is located in the expansion chamber from about 6 to 10 cm from the nozzle.

6. A process for forming diamond coatings as claimed in claim 4, further characterized in that the carbon containing gas is introduced into the nozzle downstream of its smallest diameter.

7. A process for forming diamond coatings as claimed in any of the preceding claims, further characterized in that the plasma-producing gas is hydrogen or a mixture of hydrogen and an inert gas.

8. A process for forming diamond coatings as claimed in any of the preceding claims, further characterized in that the carbon-containing gas is a hydrocarbon containing one to four carbon atoms.

9. A process for forming diamond coatings as claimed in claim 8, further characterized in that the hydrocarbon is methane.

10. A process for forming diamond coatings as claimed in any of claims 1-7, further characterized in that the carbon-containing gas is ethanol, acetone, or carbon monoxide.

11. A process for forming diamond coatings as claimed in any of the preceding claims, further characterized in that the temperature of the plasma gas stream prior to expansion is in the range from about 500 to about 2000° K.

12. A process for forming diamond coatings as claimed in any of the preceding claims, further characterized in that the temperature of the plasma gas stream prior to expansion is in the range from about 1300 to about 1800° K.

FIG. 1

EP 0 394 735 A2

April 9, 1990
Calcote No. 1

FIG. 2

EP 0 394 735 A2

FIG. 3

EP 0 394 735 A2